# EUROPÄISCHE PATENTSCHRIFT

(11) **EP 2 426 696 B1**
(45) Veröffentlichungstag und Bekanntmachung des Hinweises auf die Patenterteilung: **15.03.2017**
(21) Anmeldenummer: 11179832.8
(22) Anmeldetag: 02.09.2011
(51) Int. Cl.: H01J 37/305, H01J 37/18

(54) **Ionenstrahlvorrichtung zur Bearbeitung eines Substrats mittels eines Ionenstrahls**
Ion beam device for processing a substrate using an ion beam
Dispositif de faisceau d'ions pour le de traitement d'un substrat à l'aide d'un faisceau d'ions

(30) Priorität: 07.09.2010 DE 102010040324
(43) Veröffentlichungstag der Anmeldung: 07.03.2012
(73) Patentinhaber: asphericon GmbH, 07747 Jena (DE)
(72) Erfinder: Kiontke, Sven, 07743 Jena (DE)
(74) Vertreter: Liedtke, Markus

(56) Entgegenhaltungen:
- EP-A1- 0 474 108
- DE-A1-102008 049 655
- GB-A- 2 455 121
- JP-A- 9 245 716
- US-A1- 2005 199 806
- US-A1- 2007 075 274
- US-A1- 2008 110 745

## Beschreibung

Die Erfindung betrifft eine Ionenstrahlvorrichtung zur Bearbeitung eines Substrats mittels eines Ionenstrahls, umfassend eine Ionenstrahlquelle zur Erzeugung des Ionenstrahls und zumindest eine zwischen der Ionenstrahlquelle und dem Substrat angeordnete Blende zur Einstellung eines Querschnitts des Ionenstrahls, wobei der Ionenstrahl durch die Blende führbar ist und wobei die Blende aus kohlenstoffhaltigem Material gebildet ist.

Aus dem Stand der Technik ist es allgemein bekannt, dass besonders für so genannte Mikro- und Nanotechnologien eine genaue Bearbeitung von Oberflächen eines Substrats erfolgt. Sowohl eine Fertigung gezielt vorgebbarer Schichtdicken durch ein so genanntes Abdünnen von Schichten in der Dünnschichttechnologie und ein gezielter Abtrag einzelner Atomlagen als auch eine Nano-Profilierung von so genannten high-grade-Oberflächen werden mittels Ionenstrahlen durchgeführt.

Neben geometrischen Änderungen einer Oberflächentopographie des Substrats, die durch Abtragungen oder Beschichtungen durchgeführt werden, sind bei den Mikro- und Nanotechnologien auch lokale Änderungen von Eigenschaften der Oberfläche von Bedeutung. Es ist bekannt, dass bei ionenstrahlgestützten Abscheidungsverfahren durch ein gleichzeitiges Auftreffen von Ionen während der Beschichtung auf dem Substrat die Eigenschaften der abgeschiedenen Schicht beeinflusst werden. Damit ist eine Dichte der abgeschiedenen Schicht variabel vorgebbar und ein Wachstum der Schicht von amorphen zu kristallinen Zuständen änderbar. Auch ist eine Stöchiometrie der Schicht beeinflussbar.

Aus dem Stand der Technik sind allgemein Verfahren zur Bearbeitung eines Substrats mittels eines Ionenstrahls und Ionenstrahlvorrichtungen zur Bearbeitung eines Substrats bekannt. Die Ionenstrahlvorrichtung umfasst eine Ionenstrahlquelle zur Erzeugung des Ionenstrahls, wobei der Ionenstrahl zur Bearbeitung des Substrats auf zumindest eine Oberfläche desselben geführt wird. Bei der Bearbeitung der Oberfläche wird eine definierte Oberflächenstruktur eingebracht oder die Oberfläche in Teilbereichen oder vollständig geglättet oder Oberflächenformabweichungen durch lokalen Abtrag reduziert. Dabei werden unter der definierten Oberflächenstruktur alle auf definierte Flächenbereiche der Oberfläche bezogenen physikalischen und chemischen Eigenschaften sowie eine Oberflächentopografie verstanden. Zur genauen Positionierung und Dimensionierung des Ionenstrahls auf der Oberfläche und zur Einstellung von dessen Querschnitt ist eine Blende vorgesehen, welche zwischen der Ionenstrahlquelle und dem Substrat angeordnet ist.

Ein derartiges Verfahren und eine derartige Vorrichtung zur Ionenstrahlbearbeitung einer Oberfläche eines Substrates offenbart die EP 1 680 800 B1, wobei das Substrat gegenüber einem Ionenstrahl, der von einer Ionenstrahlquelle erzeugt wird, positioniert wird. Ein bekanntes Eigenschaftsmuster der Oberfläche des Substrates wird durch den Ionenstrahl partiell derart bearbeitet, dass ein neues technologisch definiertes Eigenschaftsmuster ausgebildet wird. Dabei wird das aktuelle geometrische Wirkungsmuster des Ionenstrahls auf der Oberfläche des Substrates in Abhängigkeit des bekannten Eigenschaftsmusters und des neuen technologisch definierten Eigenschaftsmusters sowie in Abhängigkeit des Verfahrensfortschrittes durch Veränderung der Strahlcharakteristik und/oder durch Pulsung des Ionenstrahles eingestellt. Bei der Bearbeitung der Oberfläche mit dem Ionenstrahl wird ein Materialabtragsvolumen mittels einer Verweildauer des Ionenstrahls, eines Stromflusses und einer Energieverteilung des Ionenstrahls bestimmt.

Weiterhin offenbart die DE 41 08 404 A1 ein Verfahren zur Steuerung einer Ionenstrahlbearbeitung von Festkörperoberflächen unter Verwendung einer Breitstrahlionenquelle. Ein zwischen der Breitstrahlionenquelle und einer zu bearbeitenden Festkörperoberfläche befindliches System aus mindestens drei unabhängig voneinander auf einer Geraden bewegbaren Blenden wird erfindungsgemäß auf der Basis von Korrekturdaten sowie Randbedingungen über ein Digitalrechner-Stellgliedsystem nach einer Simulationsbearbeitungsstrategie in Lage-, Form- und Öffnungszeit zur zonalen und lokalen Oberflächenbearbeitung zeitoptimiert verändert, so dass entsprechend der Genauigkeitsanforderungen eine beliebige Oberflächenbearbeitung durchführbar ist.

Die EP 2 026 373 A1 beschreibt eine Positioniereinrichtung zum Positionieren einer Blende in einem Ionenstrahl einer Ionenimplantationsanlage. Die Positioniereinrichtung umfasst zwei mittels mindestens eines Positionierantriebs relativ zueinander verstellbare Vorrichtungsteile, von denen das eine mit einer ortsfest zu einer Ionenstrahlquelle angeordneten Widerlagerstelle und das andere mit der Blende verbindbar oder verbunden ist. Das zweite Vorrichtungsteil ist zusammen mit einer daran angeordneten Masseplatte, einer Elektrodenplatte und der Blende mit Hilfe von elektrischen Positionierantrieben in den drei Raumrichtungen relativ zum Ionenstrahl positionierbar. Die Blende besteht aus für den Ionenstrahl undurchlässigem Graphit.

Aus der JP 62018030 A ist ein Verfahren zur Verbesserung eines Betriebs einer Ionenstrahl-Ätzvorrichtung bekannt, wobei ein Ätzbereich periodisch mit einem Reinigungsplasma zur Reinigung zwischen kontinuierlichen Ätzprozessen beaufschlagt wird. Als Reinigungsplasma wird ein sauerstoffhaltiges Gas verwendet, welche in den Ätzbereich zwischen eine den Ionenstrahl erzeugende Ionenquelle und ein mittels des Ionenstrahls zu bearbeitendes Substrat geführt wird. Dabei wird in dem Ätzbereich abgeschiedener Kohlenstoff mit dem sauerstoffhaltigen Gas oxidiert, so dass Kohlenstoffdioxid oder Kohlenstoffmonooxid entsteht, welches durch eine Absaugöffnung abgeführt wird.

Ferner sind aus der US 6,394,109 B1 eine Vorrichtung und ein Verfahren zur Entfernung von Kohlenstoff-Verunreinigungen bekannt. Die Kohlenstoff-Verunreinigungen entstehen während der Herstellung von Halbleiterwafern in einem Lithografieverfahren mit geladenen Teilchen auf einer Maske oder in einer Bearbeitungskammer zur Durchführung der Herstellung. Die Kohlenstoff-Verunreinigungen werden mittels eines Oxidationsmittels von der Maske oder aus der Bearbeitungskammer entfernt. In der Bearbeitungskammer befindet sich eine Quelle zur Erzeugung der geladenen Teilchen, wobei das Oxidationsmittel ungerichtet in die Bearbeitungskammer eingeleitet wird. Das Oxidationsmittel umfasst Bestandteile von Sauerstoff, Ozon, Distickstoffmonooxid, Wasserdampf, dotierte Sauerstoff-Verbindungen und Alkohole.

Die GB 2 455 121 A beschreibt Teilchenstrahlvorrichtung mit Mitteln zur Reduktion einer Kontamination in einer Teilchenstrahlsäule. Die Mittel umfassen eine Gaszuführungseinheit zur Zuführung eines Gases in einen Bereich zwischen Strahlaustritt der Teilchenstrahlsäule und einem Eingang einer Kammer, in welcher eine mittels des Teilchenstrahls zu bearbeitendes Substrat angeordnet ist. Weiterhin beschreibt die US 2005/0199806 A1 eine Vorrichtung und ein Verfahren zur Führung eines Gases in einen geladenen Teilchenstrahl zwischen eine Öffnung und ein mittels des Teilchenstrahls zu bearbeitendes Substrat. Dabei wird das Gas in einen Bereich geführt, in welchen der Teilchenstrahl auf das Substrat trifft.

Ferner beschreibt die DE 10 2008 049 655 A1 ein Partikelstrahlsystem mit einer Partikelquelle, einem Partikelstrahlformungselement, z.B. einer Blende, einem Gaszuführsystem, das dazu dient eine aktivierbare Substanz dem Partikelstrahlformungselement herum zuzuführen, und einem Vakuummantel zur Begrenzung eines evakuierbaren Innenraums.

Aus der EP 0 474 108 A1 ist eine Ionenimplantationsvorrichtung mit einem Probenhalter und mit einem Faraday-Messgerät bekannt, welches als Durchgang eines auf die Probe geführten Ionenstrahls wirkt. Das Messgerät ist mit einer Gaseinlassöffnung zum Einführen eines Reaktionsgases in den Ionenstrahldurchgang vorgesehen. Dabei wird das Reaktionsgas ionisiert und zum Entfernen eines an der Ionenimplantationsvorrichtung anhaftenden Flecks verwendet.

Eine weitere Ionenstrahlvorrichtung ist aus der US 2007/0075274 A1 bekannt. Diese Ionenstrahlvorrichtung enthält ein Gaszuführsystem, wobei das Gas mit dem mittels des Ionenstrahls aus Öffnungen gelösten Kohlenstoff reagiert.

Der Erfindung liegt die Aufgabe zu Grunde, eine gegenüber dem Stand der Technik verbesserte Ionenstrahlvorrichtung zur Bearbeitung eines Substrats anzugeben.

Die Aufgabe wird erfindungsgemäß mit einer Ionenstrahlvorrichtung gelöst, welche die im Anspruch 1 angegebenen Merkmale aufweist.

Vorteilhafte Ausgestaltungen der Erfindung sind Gegenstand der Unteransprüche. Die Ionenstrahlvorrichtung zur Bearbeitung eines Substrats mittels eines Ionenstrahls umfasst eine Ionenstrahlquelle zur Erzeugung des Ionenstrahls und zumindest eine zwischen der Ionenstrahlquelle und dem Substrat angeordnete Blende zur Einstellung eines Querschnitts des Ionenstrahls, wobei der Ionenstrahl durch die Blende führbar ist und wobei die Blende aus kohlenstoffhaltigem Material gebildet ist.

Erfindungsgemäß ist eine Zuführungseinheit zur Zuführung eines mit Kohlenstoff reaktiven Eduktes vorgesehen, wobei die Zuführungseinheit derart angeordnet ist, dass das Edukt in einer gerichteten Strömung zwischen die Blende und das Substrat führbar ist, so dass mittels des Ionenstrahls aus der Blende gelöster Kohlenstoff oxidiert. Weiterhin ist erfindungsgemäß der äußere, dem Substrat zugewandte Bereich der Blende kegelstumpfförmig ausgebildet.

Dadurch ist es möglich, mittels des Ionenstrahls von der Blende abgelösten Kohlenstoff zu oxidieren und somit ein Eindringen des Kohlenstoffs in die Oberfläche des Substrats oder eine Ablagerung des Kohlenstoffs auf der Oberfläche des Substrats zu vermeiden oder zumindest zu verringern. Daraus resultiert in vorteilhafter Weise, dass Substrate mit einer besonders hohen Oberflächengüte herstellbar sind. Insbesondere optische Substrate, wie beispielsweise Linsen, erfordern eine besonders hohe Oberflächengüte und Reinheit des Materials, welche durch die Anwendung der erfindungsgemäßen Ionenstrahlvorrichtung in einer besonders einfachen, genauen und effizienten Weise sichergestellt werden können, indem die Oberfläche des Substrats insbesondere glättbar und/oder formkorrigierbar ist. Eine Integration der Zuführungseinheit ist dabei mit geringem Material-, Montage- und Kostenaufwand durchführbar, so dass es mit besonders geringem Aufwand möglich ist, in einfacher, genauer und effizienter Weise die Oberfläche des Substrats zu bearbeiten und gleichzeitig ein Eindringen des Kohlenstoffs in die Oberfläche des Substrats oder eine Ablagerung des Kohlenstoffs auf der Oberfläche des Substrats zu vermeiden oder zumindest zu verringern. Aufgrund der kegelstumpfförmigen Ausbildung des äußeren, dem Substrat zugewandten Bereichs der Blende wird überraschenderweise ein Ablagern von Kohlenstoff auf dem zu bearbeitenden Substrat zusätzlich reduziert, da Ionen, die vom Substrat reflektiert werden und die Blende von außen treffen, aus derselben Kohlenstoff allenfalls in einer Richtung herauslösen, die nicht in Richtung des Substrates verläuft.

In einer besonders vorteilhaften Ausgestaltung ist der oxidierte Kohlenstoff in der Strömung des Eduktes abführbar, so dass ein Auftreffen des oxidierten Kohlenstoffs auf die Oberfläche des Substrats verhindert wird. Daraus resultiert eine optimierte Oberflächenbearbeitung und Oberflächengüte des Substrats.

Gemäß einer Weiterbildung der erfindungsgemäßen Ionenstrahlvorrichtung ist die Blende demontierbar und/oder vollständig aus einem Ausbreitungsbereich des Ionenstrahls schwenkbar. Somit sind zum einen in einfacher Weise verschiedene Blenden zwischen der Ionenstrahlquelle und dem Substrat anordbar, so dass verschiedene Ionenstrahle erzeugbar sind und unterschiedliche Oberflächenbearbeitungen des Substrats möglich sind. Zum anderen resultiert aus der Demontierbarkeit und/oder Verschwenkbarkeit der Blende der Vorteil, dass diese zum flächigen Aufbringen des Ionenstrahls vollständig außerhalb des Bereichs zwischen der Ionenstrahlquelle und dem Substrat positionierbar ist.

In einer besonders vorteilhaften Ausgestaltung der erfindungsgemäßen Ionenstrahlvorrichtung sind mehrere Blenden verschwenkbar im Bereich zwischen der Ionenstrahlquelle und dem Substrat angeordnet, wobei die Blenden vorzugsweise revolverartig angeordnet sind. Daraus resultiert eine Verringerung des Aufwands beim Wechsel der Blenden für die unterschiedlichen Oberflächenbearbeitungen des Substrats.

Zur Abführung des oxidierten Kohlenstoffs ist in einer Ausgestaltung der erfindungsgemäßen Ionenstrahlvorrichtung eine Absaugeinheit vorgesehen. Hieraus ergeben sich die Möglichkeit einer effektiven und vollständigen Abführung des oxidierten Kohlenstoffs und insbesondere die gezielte Zuführung der Reaktionsprodukte in eine Filter- und/oder Katalysatoreinheit zur Reinigung der bei der Reaktion des Kohlenstoffs mit dem Edukt entstehenden Reaktionsprodukte.

Eine besondere Ausgestaltung der Erfindung sieht vor, dass die Blende aus Kohlenstoff mittels einer Kühleinrichtung gekühlt wird. Dadurch wird der Anteil des durch den Ionenstrahl aus der inneren Oberfläche der Blende heraus gelösten Kohlenstoffs reduziert. Zudem haftet außen vom Substrat auf die Blende zurückgesputtertes Material besser an der Blende an, so dass der Grad an Verschmutzung auf dem Substrat wirksam reduziert wird.

Die Innenseite der Blende weist gemäß einer weiteren unabhängigen Ausgestaltung der Erfindung Abschnitte auf, die im Wesentlichen senkrecht zum Ionenstrahl, verlaufen, deren Normale also eine Neigung von weniger als 30°, besonders bevorzugt weniger als 20°, zur Richtung des Ionenstrahls aufweisen, so dass Ionen, die auf diese Abschnitte der Blende treffen, aus derselben Kohlenstoff im Wesentlichen in einer Richtung herauslösen, die ebenfalls nicht in Richtung des Substrates verläuft.

Das Edukt ist insbesondere ein Plasma oder Gas, welches jeweils einfach und sehr genau in den Raum zwischen der Blende und dem Substrat führbar ist.

Zur Erzielung einer möglichst vollständigen Oxidation des Kohlenstoffs ist das Gas in einer Ausgestaltung aus Sauerstoff, Ozon, Distickstoffmonooxid, Wasserdampf und/oder sauerstoffhaltigen Verbindungen gebildet und/oder es wird ein sauerstoffhaltiges Plasma verwendet.

Um eventuell in die Oberfläche des Substrats eingetragenen und/oder auf der Oberfläche des Substrats abgelagerten Kohlenstoff nach der Bearbeitung der Oberfläche zu entfernen, ist gemäß einer besonderen Ausführungsform ein sauerstoffhaltiges Plasma, beispielsweise ein Sauerstoffplasma, auf die Oberfläche des Substrats führbar. Hierdurch wird nicht oder nur teilweise oxidierter Kohlenstoff von der Oberfläche gelöst und somit die Oberflächengüte des Substrats weiter verbessert.

Ein besonderer Vorteil der Verwendung des sauerstoffhaltigen Plasmas zum Abtrag des verbliebenen Kohlenstoffs von der Oberfläche ist, dass Kohlenstoff auch dann besonders effektiv oxidiert, wenn er bereits abgelagert und damit selbst wenig reaktiv ist, so dass im Wesentlichen der Kohlenstoff abgetragen wird und ein zusätzlicher Abtrag von Oberflächenmaterial des Substrats minimiert wird.

Alternativ oder zusätzlich ist nach der Bearbeitung der Oberfläche mittels des Ionenstrahls die Blende entfernbar und auf die Oberfläche des Substrats ist ein kohlenstofffreier Ionenstrahl führbar, um eventuell in die Oberfläche des Substrats eingetragenen und/oder auf der Oberfläche des Substrats abgelagerten Kohlenstoff nach der Bearbeitung der Oberfläche zu entfernen.

Besonders bevorzugt wird das Edukt im Bereich eines Fokus eines fokussierten Ionenstrahls und/oder im Bereich einer mittels des Ionenstrahls zu bearbeitenden Stelle des Substrates zugeführt.

Bevorzugt wird ein Ionenstrahl mit Ionen einer Geschwindigkeit zwischen 300 eV und 1.300 eV, insbesondere zwischen 600 eV und 1.000 eV oder zwischen 700 eV und 900 eV verwendet. Dadurch ist einerseits ein Energieeintrag hoch genug, um eine wirksame Oberflächenbearbeitung zu ermöglichen und andererseits gering genug, um eine tiefgehende Zerstörung der Oberfläche des Substrates zu verhindern. Die Geschwindigkeit der Ionen bestimmt die Energie des Ionenstrahls und ist durch die Größe einer Beschleunigungsspannung einstellbar, die an die Gitter der Bündelungseinheit angelegt wird.

Ausführungsbeispiele der Erfindung werden im Folgenden anhand von Zeichnungen näher erläutert.

Darin zeigen:
- Figur 1: schematisch ein Ausführungsbeispiel einer ersten Ausführungsform einer erfindungsgemäßen Ionenstrahlvorrichtung zur Bearbeitung eines Substrats mittels eines Ionenstrahls,
- Figur 2: eine ausschnittsweise schematische frontale Ansicht einer zweiten Ausführungsform einer erfindungsgemäßen Ionenstrahlvorrichtung und
- Figur 3: schematisch ein Ausführungsbeispiel einer ersten Ausführungsform einer Blende der erfindungsgemäßen Ionenstrahlvorrichtung.

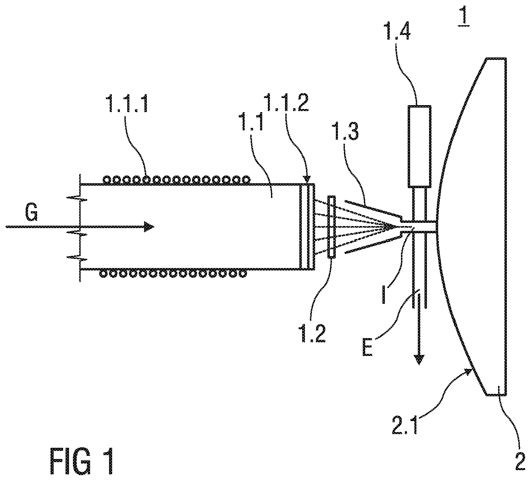

In **Figur 1** ist ein Ausführungsbeispiel der erfindungsgemäßen Ionenstrahlvorrichtung 1 zur Bearbeitung eines Substrats 2 mittels eines Ionenstrahls I dargestellt.

Bei dem Substrat 2 handelt es sich um ein als optische Linse, Spiegel, etc, ausgebildetes Werkstück, wobei mittels des Ionenstrahls I eine definierte Struktur in eine Oberfläche 2.1 der Linse eingebracht wird oder die Oberfläche 2.1 geglättet und/oder formkorrigiert wird.

Zur Erzeugung des Ionenstrahls I umfasst die Ionenstrahlvorrichtung 1 eine Ionenstrahlquelle 1.1, welcher ein Argon-Gas G zugeführt wird. Das Argon-Gas G wird dabei insbesondere mit einem Volumenstrom von 3 scm³/s (Standardkubikzentimeter pro Sekunde) bis 5 scm³/s zugeführt. Alternativ ist die Verwendung anderer Gase möglich. Ebenso sind alternativ andere Volumenströme möglich, wobei der Volumenstrom vorzugsweise individuell einstellbar ist.

Der Ionenstrahl I wird durch Beschleunigung der Ionen des Argon-Gases G erzeugt, wobei zur Erzeugung eines Plasmas in einem Topf 1.1.3 eine elektrische Spule 1.1.1 vorgesehen ist, welche ein elektrisches Wechselfeld erzeugt. Der Ionenstrahl I wird gebildet, indem Ionen mittels einer Bündelungseinheit 1.1.2, welche bevorzugt durch drei gekrümmte und unterschiedlich elektrisch geladene Gitter aus Kohlenstoff gebildet wird, aus dem Plasma herausgelöst und in Richtung des zu bearbeitenden Substrates 2 beschleunigt werden.

Innerhalb der Ionenstrahlvorrichtung 1 herrscht ein so genanntes Hochvakuum. Dabei sind die Ionenstrahlquelle 1.1 und das Substrat 2 innerhalb eines nicht näher dargestellten und weitestgehend leeren Raumes angeordnet, in welchem das Hochvakuum erzeugt wird.

Beim Auftreffen des Ionenstrahls I auf die Oberfläche 2.1 des Substrats 2 findet eine Impulsübertragung von den im Ionenstrahl I befindlichen hochenergetischen Ionen auf das Substrat 2 statt, so dass Moleküle und/oder Atome aus der Oberfläche 2.1 des Substrats 2 herausgelöst und somit abgetragen werden. Dieser Prozess wird auch als Sputtern bezeichnet.

In Austrittsrichtung des Ionenstrahls I nach der Bündelungseinheit 1.1.2 ist weiterhin eine Glühwendel 1.2 angeordnet, mittels welcher Elektronen mit einer geringen Energie erzeugt werden. Diese Elektronen rekombinieren auf der Oberfläche 2.1 mit den Argon-Ionen des Ionenstrahls I nach deren Auftreffen auf der Oberfläche 2.1. Somit wird verhindert, dass es zu einer durch den Beschuss der Oberfläche 2.1 mit den Argon-Ionen hervorgerufene positiven elektrischen Aufladung der Oberfläche 2.1 des Substrats 2 kommt. Das heißt, das Substrat 2 bleibt elektrisch neutral.

Zur gerichteten Führung des Ionenstrahls I und zur Einstellung eines Querschnitts des Ionenstrahls I, insbesondere zur Einstellung des Querschnitts des Ionenstrahls I auf der Oberfläche 2.1 des Substrats 2, umfasst die Ionenstrahlvorrichtung 1 eine Blende 1.3. Dadurch ist es möglich, den Ionenstrahl I auf definierte Positionen auf der Oberfläche 2.1 zu führen.

Die Blende 1.3 ist zwischen der Ionenstrahlquelle 1.1 und dem Substrat 2 angeordnet und weist am Ausgang einen definierten Durchmesser auf, mittels welchem eine Reduktion der Leistung des Ionenstrahls I, insbesondere ein Bearbeitungsdurchmesser desselben, vorgebbar ist und somit der Abtrag von der Oberfläche 2.1 regulierbar ist. Der Durchmesser der Austrittsöffnung der Blende 1.3 ist zum Beispiel derart gewählt, dass 50% oder 90% oder 99% der Argon-Ionen aus dem Ionenstrahl I abgeschattet bzw. zurückgehalten werden.

Die Blende 1.3 ist vorzugsweise in einem Abstand von 6 mm vor der Oberfläche 2.1 des Substrats 2 angeordnet. Alternativ sind auch andere Abstände möglich, wobei das Substrat 2 relativ zur Blende 1.3, die Blende 1.3 relativ zum Substrat 2 und/oder die Blende 1.3 relativ zur Ionenstrahlquelle 1.1 variabel anordbar sind. Der Abstand zwischen der Blende 1.3 und der Oberfläche 2.1 beträgt insbesondere 2 mm bis 10 mm. Auch ist vorzugsweise ein Abstand zwischen der Ionenstrahlquelle 1.1 und dem Substrat 2 variabel einstellbar. Ebenso ist bevorzugt ein Abstand zwischen der Ionenstrahlquelle 1.1 und der Blende 1.3 variabel einstellbar.

In einem nicht näher dargestellten Ausführungsbeispiel umfasst die Ionenstrahlvorrichtung 1 mehrere Blenden 1.3, welche revolverartig angeordnet sind. Die Blenden 1.3 weisen verschiedene Maße, insbesondere verschiedene Durchmesser und/oder Formen der Auslassöffnungen auf, um verschiedene Querschnitte des Ionenstrahls I zu erzeugen.

Die Blenden 1.3 sind dabei drehbar bzw. schwenkbar vor der Ionenstrahlquelle 1.1 angeordnet, so dass die gewünschten Eigenschaften des Ionenstrahls I durch einfaches Verdrehen des Revolvers und die daraus folgende Positionierung der jeweiligen Blende 1.3 zwischen der Oberfläche 2.1 des Substrats 2 und der Ionenstrahlquelle 1.1 vorgebbar sind. Ein beispielhafter Revolver weist vier Blenden 1.3 auf, die durch verschiedene Durchmesser der Auslassöffnung gekennzeichnet sind. Die Durchmesser betragen 3 mm, 1,5 mm, 1 mm und 0,5 mm. Alternativ sind Revolver mit einer abweichenden Anzahl an Blenden 1.3 und/oder abweichenden Blendendurchmessern möglich. Bevorzugt ist eine Position einstellbar, in der die Blende den Ionenstrahl I überhaupt nicht beeinflusst, insbesondere reduziert.

Um die Abschattung bzw. Zurückhaltung der Argon-Ionen zu ermöglichen, ist es erforderlich, dass die Blende 1.3 aus für den Ionenstrahl I undurchlässigem Material besteht. Besonders geeignet ist hierfür Graphit, d. h. Kohlenstoff, da dieser eine geringe Sputterrate aufweist. Jedoch wird durch den Ionenstrahl I Kohlenstoff aus dem festen Verbund der Blende 1.3 gelöst und teilweise mit dem Ionenstrahl I in Richtung der Oberfläche 2.1 des Substrats 2 transportiert.

Da der aus der Blende 1.3 gelöste Kohlenstoff eine relativ geringe Energie von ungefähr 10 eV aufweist, haftet dieser besonders gut auf der Oberfläche 2.1 des Substrats. Aus den Anhaftungen des Kohlenstoffs resultiert eine Verschlechterung der Oberflächengüte des Substrats 2, insbesondere eine Verschlechterung der optischen Eigenschaften der Linse, insbesondere eine Verschlechterung ihrer Transmission. Deshalb ist es erforderlich, Kohlenstoffanhaftungen an der Oberfläche 2.1 des Substrats 2 und ein Eindringen des Kohlenstoffs in das Substrat 2 zu vermeiden oder zumindest zu verringern.

Zu diesem Zweck umfasst die Ionenstrahlvorrichtung 1 eine
Zuführungseinheit 1.4, mittels welcher ein mit Kohlenstoff reaktives Edukt E in einer gerichteten Strömung zwischen die Blende 1.3 und die zu bearbeitende Oberfläche 2.1 des Substrats 2 geführt wird. Das Edukt E ist ein sauerstoffhaltiges Gas, welches bei der chemischen Reaktion mit Kohlenstoff zu einer Oxidation des Kohlenstoffs gemäß folgender Gleichung führt:

2C + O₂ → 2CO. [1]

Dabei entsteht als Reaktionsprodukt Kohlenstoffmonooxid.

Alternativ oder zusätzlich wird der Kohlenstoff gemäß folgender Gleichung zu Kohlenstoffdioxid oxidiert:

C + O₂ → CO₂. [2]

Um die Oxidation des Kohlenstoffs zu realisieren, werden als Edukt E, d. h. als Gas, Sauerstoff, Ozon, Distickstoffmonooxid, Wasserdampf und/oder andere sauerstoffhaltige Verbindungen verwendet, welche mit der Zuführungseinheit 1.4 in der gerichteten Strömung zwischen die Blende 1.3 und die Oberfläche 2.1 des Substrats 2 geführt werden. Um eine Beschädigung oder Zerstörung der Blende 1.3 zu vermeiden, wird das Edukt E berührungsfrei an der Blende 1.3 vorbeigeführt.

Das Edukt E wird dabei insbesondere mit einem Volumenstrom von 0,3 cm³/s bis 0,5 cm³/s zugeführt. Alternativ sind andere Volumenströme möglich, wobei der Volumenstrom vorzugsweise individuell einstellbar ist. Vorteilhafterweise beträgt der Volumenstrom des Edukts E zwischen 5% und 15%, besonders bevorzugt 10%, des Volumenstroms des eingeleiteten Argon-Gases.

Um eventuell nicht oxidierten Kohlenstoff, welcher sich auf der Oberfläche 2.1 des Substrats 2 abgelagert hat, von dieser zu entfernen, wird nach der mittels des Ionenstrahls I durchgeführten Bearbeitung der Oberfläche 2.1 des Substrats 2 ein sauerstoffhaltiges Plasma auf die Oberfläche 2.1 des Substrats 2 geführt, mittels welchem der Kohlenstoff oxidiert und von der Oberfläche 2.1 abgetragen wird. Die Oberfläche 2.1 des Substrats 2 selbst wird dabei nicht oder nicht wesentlich verändert.

Alternativ oder zusätzlich wird hierzu die Blende 1.3 nach der Bearbeitung der Oberfläche 2.1 mit dem Ionenstrahl I demontiert oder vollständig aus dem Ausbreitungsbereich des Ionenstrahls geschwenkt. Alternativ wird das Substrat 2 zu einer zweiten Quelle bewegt, welche ein sauerstoffhaltiges Plasma emittiert.

Ferner kann zusätzlich nach der mittels des Ionenstrahls I durchgeführten Bearbeitung der Oberfläche 2.1 des Substrats 2 ein kohlenstofffreier oder zumindest kohlenstoffarmer Ionenstrahl I geführt werden, mittels welchem der Kohlenstoff von der Oberfläche 2.1 abgetragen wird. Ein zumindest kohlenstoffarmer Ionenstrahl I ist erzeugbar, indem keine Blende aus Kohlenstoff verwendet wird; ein derartiger Ionenstrahl I weist nur einen geringen Anteil von Kohlenstoff auf, der aus den aus Kohlenstoff bestehenden Gittern der Bündelungseinheit 1.1.2 herausgelöst wurden.

Besonders effektiv ist es, zur Entfernung von nicht oxidierten Kohlenstoff, welcher sich auf der Oberfläche 2.1 des Substrats 2 abgelagert hat, eine Ionenstrahlvorrichtung mit Bündelungseinheit 1.1.2, aber ohne Blende 1.3 zu verwenden und dabei mittels der Zuführungseinheiten 1.4 das Edukt E zuzuführen.

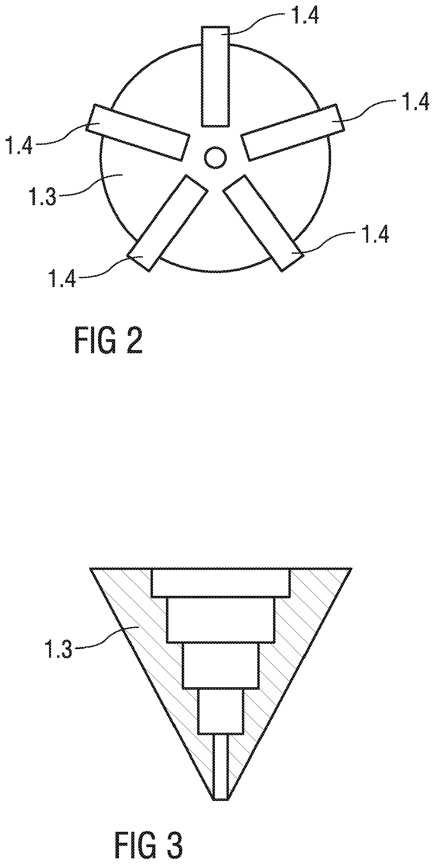

In **Figur 2** ist ein Ausführungsbeispiel gezeigt, bei welchem mehrere Zuführungseinheiten 1.4 im Bereich der Blende 1.3 angeordnet sind.

**Figur 3** zeigt ein Ausführungsbeispiel der Blende 1.3, deren äußerer, dem Substrat 2 zugewandter Bereich im Bereich seiner Öffnung geneigt ausgebildet ist, so dass der Öffnungsbereich der Blende 1.3 von außen kegelstumpfförmig ist. Dadurch wird überraschenderweise ein Ablagern von Kohlenstoff auf dem zu bearbeitenden Substrat 2 zusätzlich reduziert, da Ionen, die vom Substrat 2 reflektiert werden und die Blende 1.3 von außen treffen, aus derselben Kohlenstoff allenfalls in einer Richtung herauslösen, die nicht in Richtung des Substrates 2 verläuft.

Die Innenseite der Blende 1.3 weist gemäß einer weiteren unabhängigen Ausgestaltung der Erfindung Abschnitte auf, die im Wesentlichen senkrecht zum Ionenstrahl I, verlaufen, deren Normale also eine Neigung von weniger als 30°, besonders bevorzugt weniger als 20°, zur Richtung des Ionenstrahls I aufweisen, so dass Ionen, die auf diese Abschnitte der Blende 1.3 treffen, aus derselben Kohlenstoff im Wesentlichen in einer Richtung herauslösen, die ebenfalls nicht in Richtung des Substrates 2 verläuft.

### BEZUGSZEICHENLISTE

- 1: Ionenstrahlvorrichtung
- 1.1: Ionenstrahlquelle
- 1.1.1: Spule
- 1.1.2: Bündelungseinheit
- 1.1.3: Topf
- 1.2: Glühwendel
- 1.3: Blende
- 1.4: Zuführungseinheit
- 2: Substrat
- 2.1: Oberfläche

- E: Edukt
- G: Argon-Gas
- I: Ionenstrahl

## Patentansprüche

1. Ionenstrahlvorrichtung (1) zur Bearbeitung eines Substrats (2) mittels eines Ionenstrahls (I), umfassend eine Ionenstrahlquelle (1.1) zur Erzeugung des Ionenstrahls (I) und zumindest eine zwischen der Ionenstrahlquelle (1.1) und dem Substrat (2) angeordnete Blende (1.3) zur Einstellung eines Querschnitts des Ionenstrahls (I), wobei der Ionenstrahl (I) durch die Blende (1.3) führbar ist,
**dadurch gekennzeichnet, dass** eine Zuführungseinheit (1.4) zur Zuführung eines mit Kohlenstoff reaktiven Eduktes (E) vorgesehen ist, wobei die Zuführungseinheit (1.4) derart angeordnet ist, dass das Edukt (E) in einer gerichteten Strömung zwischen die aus kohlenstoffhaltigem Material gebildete Blende (1.3) und das Substrat (2) führbar ist, so dass mittels des Ionenstrahls (I) aus der Blende (1.3) gelöster Kohlenstoff oxidiert, wobei der äußere, dem Substrat (2) zugewandte Bereich der Blende (1.3) kegelstumpfförmig ausgebildet ist.

2. Ionenstrahlvorrichtung (1) nach Anspruch 1,
**dadurch gekennzeichnet, dass** die Blende (1.3) demontierbar und/oder vollständig aus einem Ausbreitungsbereich des Ionenstrahls (I) schwenkbar ist.

3. Ionenstrahlvorrichtung (1) nach Anspruch 1 oder 2,
**dadurch gekennzeichnet, dass** die Blende (1.3) mit einer Kühleinrichtung versehen ist.

4. Ionenstrahlvorrichtung (1) nach einem der vorhergehenden Ansprüche,
**dadurch gekennzeichnet, dass** die Innenseite der Blende (1.3) zumindest Abschnitte aufweist, die im Wesentlichen senkrecht zum Ionenstrahl (I) verlaufen.

5. Ionenstrahlvorrichtung (1) nach einem der vorhergehenden Ansprüche,
**dadurch gekennzeichnet, dass** das Edukt (E) ein Gas oder ein sauerstoffhaltiges Plasma ist.

6. Ionenstrahlvorrichtung (1) nach Anspruch 5,
**dadurch gekennzeichnet, dass** das Gas aus Sauerstoff, Ozon, Distickstoffmonooxid, Wasserdampf und/oder sauerstoffhaltigen Verbindungen gebildet ist.

7. Ionenstrahlvorrichtung (1) nach einem der vorhergehenden Ansprüche,
**dadurch gekennzeichnet, dass** der Ionenstrahl (I) Ionen einer Geschwindigkeit zwischen 300 eV und 1.300 eV, insbesondere zwischen 600 eV und 1.000 eV oder zwischen 700 eV und 900 eV umfasst.

8. Ionenstrahlvorrichtung (1) nach einem der vorhergehenden Ansprüche,
**dadurch gekennzeichnet, dass** nach der mittels des Ionenstrahls (I) durchgeführten Bearbeitung der Oberfläche (2.1) ein sauerstoffhaltiges Plasma auf die Oberfläche (2.1) des Substrats (2) führbar ist.

9. Ionenstrahlvorrichtung (1) nach einem der vorhergehenden Ansprüche,
**dadurch gekennzeichnet, dass** nach der mittels des Ionenstrahls (I) durchgeführten Bearbeitung der Oberfläche (2.1) des Substrats (2) die Blende (1.3) entfernbar ist und auf die Oberfläche (2.1) ein kohlenstofffreier oder kohlenstoffarmer Ionenstrahl (I) führbar ist, welchem das Edukt (E) zuführbar ist.

10. Ionenstrahlvorrichtung (1) nach einem der vorhergehenden Ansprüche,
**dadurch gekennzeichnet, dass** das Edukt (E) im Bereich eines Fokus des Ionenstrahls (I) und/oder im Bereich einer mittels des Ionenstrahls (I) zu bearbeitenden Stelle des Substrates (2) zuführbar ist.

## Claims

1. An ion beam device (1) for machining a substrate (2) by means of an ion beam (I), including an ion beam source (1.1) for generating the ion beam (I) and at least one orifice (1.3), disposed between the ion beam source (1.1) and the substrate (2), for adjusting a cross section of the ion beam (I), wherein the ion beam (I) is guidable through the orifice (1.3),
**characterized in that** a delivery unit (1.4) for delivering an educt (E) that is reactive with carbon is provided, and the delivery unit (1.4) is disposed such that the educt (E) can be guided in a directional flow between the orifice (1.3) which is formed of carbon-containing material and the substrate (2), so that carbon released from the orifice (1.3) by means of the ion beam (I) oxidizes, wherein the region of the orifice (1.3) oriented toward the substrate (2) is frustoconical.

2. The ion beam device (1) according to claim 1, **characterized in that** the orifice (1.3) can be taken off and/or pivoted all the way out of a propagation range of the ion beam (I).

3. The ion beam device (1) according to claim 1 or 2, **characterized in that** the orifice (1.3) is provided with a cooling device.

4. The ion beam device (1) according to any one of the preceding claims,
**characterized in that** the inside of the orifice (1.3) has at least portions which extend essentially perpendicular to the ion beam (I).

5. The ion beam device (1) according to any one of the preceding claims,
**characterized in that** the educt (E) is a gas or an oxygen-containing plasma.

6. The ion beam device (1) according to claim 5, **characterized in that** gas is composed from oxygen, ozone, dinitrogen monoxide, water vapor, and/or oxygen-containing compounds.

7. The ion beam device (1) according to any one of the preceding claims,
**characterized in that** the ion beam (I) comprises ions having a speed between 300 eV and 1300 eV, in particular between 600 eV and 1000 eV, or between 700 eV and 900 eV.

8. The ion beam device (1) according to any one of the preceding claims,
**characterized in that** after the machining of the surface (2.1) performed by means of the ion beam (I), an oxygen-containing plasma is guided onto the surface (2.1) of the substrate (2).

9. The ion beam device (1) according to any one of the preceding claims,
**characterized in that** after the machining of the surface (2.1) of the substrate (2) performed by means of the ion beam (I), the orifice (1.3) is removable, and a carbon-free or low-carbon ion beam (I), to which the educt (E) is delivered, is guidable onto the surface (2.1).

10. The ion beam device (1) according to any one of the preceding claims,
**characterized in that** the educt (E) is delivered in the vicinity of a focus of the ion beam (I) and/or in the vicinity of a point on the substrate (2) that is to be machined by means of the ion beam (I).

## Revendications

1. Dispositif à faisceau d'ions (1) destiné à traiter un substrat (2) au moyen d'un faisceau d'ions (I), comprenant une source de faisceau d'ions (1.1) destinée à générer le faisceau d'ions (I) et au moins un diaphragme (1.3) disposé entre la source de faisceau d'ions (1.1) et le substrat (2) pour régler une section transversale du faisceau d'ions (I), dans lequel le faisceau d'ions (I) peut être guidé à travers le diaphragme (1.3),
**caractérisé en ce qu'**il est prévu une unité d'amenée (1.4) destinée à amener un éduit (E) réactif avec le carbone, dans lequel l'unité d'amenée (1.4) est disposée de manière à ce que l'éduit (E) puisse être guidé dans un flux orienté entre le diaphragme (1.3) constitué d'un matériau contenant du carbone et le substrat (2), de manière à oxyder le carbone libéré au moyen du faisceau d'ions (I) à partir du diaphragme (1.3), dans lequel la région du diaphragme (1.3) extérieure et tournée vers le substrat (2) est réalisée sous une forme tronconique.

2. Dispositif à faisceau d'ions (1) selon la revendication 1,
**caractérisé en ce que** le diaphragme (1.3) est démontable et/ou **en ce qu'**il peut être entièrement pivoté en dehors d'une zone de propagation du faisceau d'ions (I).

3. Dispositif à faisceau d'ions (1) selon la revendication 1 ou 2,
**caractérisé en ce que** le diaphragme (3) est muni d'un dispositif de refroidissement.

4. Dispositif à faisceau d'ions (1) selon l'une quelconque des revendications précédentes, **caractérisé en ce que** la face interne du diaphragme (1.3) comporte au moins des sections qui s'étendent sensiblement perpendiculairement au faisceau d'ions (I).

5. Dispositif à faisceau d'ions (1) selon l'une quelconque des revendications précédentes,
**caractérisé en ce que** l'éduit (E) est un gaz ou un plasma contenant de l'oxygène.

6. Dispositif à faisceau d'ions (1) selon la revendication 5,
**caractérisé en ce que** le gaz est constitué d'oxygène, d'ozone, de monoxyde de diazote, de vapeur d'eau et/ou de composés contenant de l'oxygène.

7. Dispositif à faisceau d'ions (1) selon l'une quelconque des revendications précédentes,
**caractérisé en ce que** le faisceau d'ions (I) comprend des ions ayant une vitesse comprise entre 300 eV et 1300 eV, notamment entre 600 eV et 1000 eV, ou entre 700 eV et 900 eV.

8. Dispositif à faisceau d'ions (1) selon l'une quelconque des revendications précédentes,
**caractérisé en ce que**, après le traitement de la surface (2.1) effectué au moyen du faisceau d'ions (I), un plasma contenant de l'oxygène peut être guidé vers la surface (2.1) du substrat (2).

9. Dispositif à faisceau d'ions (1) selon l'une quelconque des revendications précédentes,
**caractérisé en ce que**, après le traitement de la surface (2.1) du substrat (2) effectué au moyen du faisceau d'ions (I), le diaphragme (1.3) peut être retiré et un faisceau d'ions (I) dépourvu de carbone ou à faible teneur en carbone peut être guidé vers la surface (2.1), vers laquelle l'éduit (E) peut être acheminé.

10. Dispositif à faisceau d'ions (1) selon l'une quelconque des revendications précédentes,
**caractérisé en ce que** l'éduit (E) peut être acheminé dans la région d'un foyer du faisceau d'ions (I) et/ou dans la région d'un point du substrat (2) qui doit être traité au moyen du faisceau d'ions (I).
